# EUROPEAN PATENT APPLICATION

(11) **EP 0 976 850 A2**
(43) Date of publication of application: **02.02.2000**
(21) Application number: 99401762.2
(22) Date of filing: 13.07.1999
(51) Int. Cl.: C23F 1/24, H01L 21/306

(54) **Apparatus and method for recycling**

(30) Priority: 21.07.1998 JP 20523498
(71) Applicant: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventor: Belot, Dominique, 9-1 Shinonome 1 chome, Koto-ku, Tokyo (JP); Dhainaut, Bernard, Air Liquide Korea Serv. Co. Ltd, Yongsan-ku, Seoul 140-210 (KR); Nagamura, TTakashi, 16 Niijima Harima-cho Kako-gun Hyogo-ken (JP); Imanaga, Tetsuya, 9-1, Shinonome 1 chome, Koto-ku, Tokyo (JP)
(74) Representative: Vesin, Jacques

(57) **Abstract**

Provided is a recycling apparatus and method. The apparatus is connected to a semiconductor cleaning apparatus engaged in cleaning semiconductor substrates with an ammonia-containing cleaning solution. The recycling apparatus recovers ammonia from a waste solution discharged from the cleaning apparatus and purifies the waste solution for re-use of the recovered ammonia in the cleaning apparatus. The recycling apparatus features a solids removal means for removing solids from the waste solution, a rectification column for rectifying the waste solution from which the solids have been removed, the column yielding concentrated aqueous ammonia at the column top, a first pipework for feeding the waste solution discharged from the semiconductor cleaning apparatus to the solids removal means, a second pipework for feeding from the solids removal means the waste solution from which the solids have been removed to the rectification column, and a third pipework for removing from the rectification column and feeding to the cleaning apparatus the concentrated aqueous ammonia. The invention enables ammonia that has already been used for cleaning during semiconductor device fabrication to be reused for that same purpose.

## Description

### BACKGROUND OF THE INVENTION

### 1. Field of the Invention

The invention relates to a recycling apparatus which enables ammonia that has already been used for cleaning during semiconductor device fabrication to be re-used for that same purpose. The invention also relates to a recycling method which can be practiced on the inventive apparatus. The invention has particular applicability to the manufacture of semiconductor devices.

### 2. Description of the Related Art

Cleaning processes are carried out during semiconductor device fabrication in order to remove contaminants that have become attached on the wafer. These contaminants include particulates, adsorbed molecules of, for example, metals and organics, and surface films such as spontaneous oxide films.

These contaminants are removed using, for example, a cleaning solution comprising ammonia (NH₃) and hydrogen peroxide (H₂O₂) dissolved in pure water. Upon the application of a cleaning solution of this type, the organics sticking or adsorbed on the wafer react with the hydrogen peroxide to produce carbon dioxide (CO₂₎ and water. The organics are thus partially or completely decomposed and thereby removed from the wafer surface. The oxides and metals sticking or adsorbed on the wafer are removed by dissolution by the ammonia.

This wafer cleaning results in the uptake by the cleaning solution of the contaminants sticking or adsorbed on the wafer surface. As a consequence, when a single cleaning solution is repeatedly used for cleaning, the contaminant concentration in the cleaning solution will undergo a cumulative increase until the cleaning solution ultimately becomes unable to deliver its full cleaning activity. In response to this, the practice in the art has been to periodically replace the cleaning solution and to discard the spent cleaning solution without recycling it.

However, semiconductor device fabrication uses very large amounts of aqueous ammonia, for example, up to 40 to 50 tons/month. As a result, the prior practice of not re-using the spent cleaning solution creates the requirement that a storage tank with a capacity of about 10 tons be continually filled with aqueous ammonia. Holding such large amounts of aqueous ammonia requires a major equipment investment in order to clear legal regulations. Moreover, this practice cannot provide good workability since the cleaning solution must be changed frequently.

In addition, high-purity aqueous ammonia and industrial grade aqueous ammonia are usually available commercially at concentrations no greater than 30 wt%. Thus, the acquisition of high-purity or industrial grade aqueous ammonia in such concentrations as the ammonia for cleaning solutions is associated with high transportation costs.

Moreover, discharge of the spent cleaning solution from the plant requires, for example, a neutralization treatment. The failure to recycle the spent cleaning solution necessitates the treatment of large amounts of cleaning solution as a waste solution, thus generating very substantial treatment costs. Finally, even with neutralization treatment, etc., the discharge of such large amounts of waste solution into the environment is undesirable per se.

In sum, the re-use for cleaning of ammonia that has already been used for cleaning is desirable for such purposes as reducing costs and reducing the amount of waste solution.

To meet the requirements of the semiconductor processing industry and to overcome the problems and disadvantages of the related art described above, it is an object of the present invention to provide a novel recycling apparatus and recycling method which make possible the re-use for the same purpose of ammonia which has previously been used for cleaning during semiconductor device fabrication.

Other objects and aspects of the present invention will become apparent to one of ordinary skill in the art upon review of the specification, drawings and claims appended hereto.

### SUMMARY OF THE INVENTION

The foregoing objectives are met by the apparatus and methods of the present invention. According to a first aspect of the present invention, a recycling apparatus is provided. The apparatus is connected to a semiconductor cleaning apparatus engaged in cleaning semiconductor substrates with an ammonia-containing cleaning solution. The recycling apparatus recovers ammonia from a waste solution discharged from the cleaning apparatus and purifies the waste solution for re-use of the recovered ammonia in the cleaning apparatus. The recycling apparatus features a solids removal means for removing solids from the waste solution, a rectification column for rectifying the waste solution from which the solids have been removed, the column yielding concentrated aqueous ammonia at the column top, a first pipework for feeding the waste solution discharged from the semiconductor cleaning apparatus to the solids removal means, a second pipework for feeding from the solids removal means the waste solution from which the solids have been removed to the rectification column, and a third pipework for removing from the rectification column and feeding to the cleaning apparatus the concentrated aqueous ammonia. The invention enables ammonia that has already been used for cleaning during semiconductor device fabrication to be re-used for that same purpose.

Preferred embodiments of the aforesaid recycling apparatus are as follows:
(1) In this preferred embodiment, the rectification column removes at least a portion of the chemical substances having a boiling point below that of ammonia in the concentrated aqueous ammonia.
(2) A purification means is also present in a second preferred embodiment. This purification means is connected to the third pipework and purifies the concentrated aqueous ammonia that has been freed of at least a portion of the chemical substances boiling below ammonia (hereinafter referred to as intermediate-purity concentrated aqueous ammonia) to produce a high-purity aqueous ammonia having an impurity concentration 30 ppb or less.
(3) In a third preferred embodiment, the cleaning solution is substantially a mixture of ammonia, hydrogen peroxide, and pure water.

The present invention also provides a recycling method for recovering ammonia from a waste solution discharged from a semiconductor cleaning apparatus engaged in cleaning semiconductor substrates with an ammonia-containing cleaning solution, and purifying the waste solution for re-use of the recovered ammonia in the cleaning. The method involves removing solids from the waste solution, and rectifying the waste solution from which the solids have been removed, thereby producing a concentrated aqueous ammonia at the column top.

Preferred embodiments of this recycling method are as follows.
(1) This preferred embodiment additionally contains a process that removes at least a portion of the chemical substances boiling below ammonia from the concentrated aqueous ammonia.
(2) This preferred embodiment additionally contains a process that purifies the aforesaid intermediate-purity concentrated aqueous ammonia to produce a high-purity aqueous ammonia having an impurity concentration of 30 ppb or less.
(3) In this preferred embodiment the aforesaid cleaning solution is substantially a mixture of ammonia, hydrogen peroxide, and water.

### BRIEF DESCRIPTION OF THE DRAWINGS

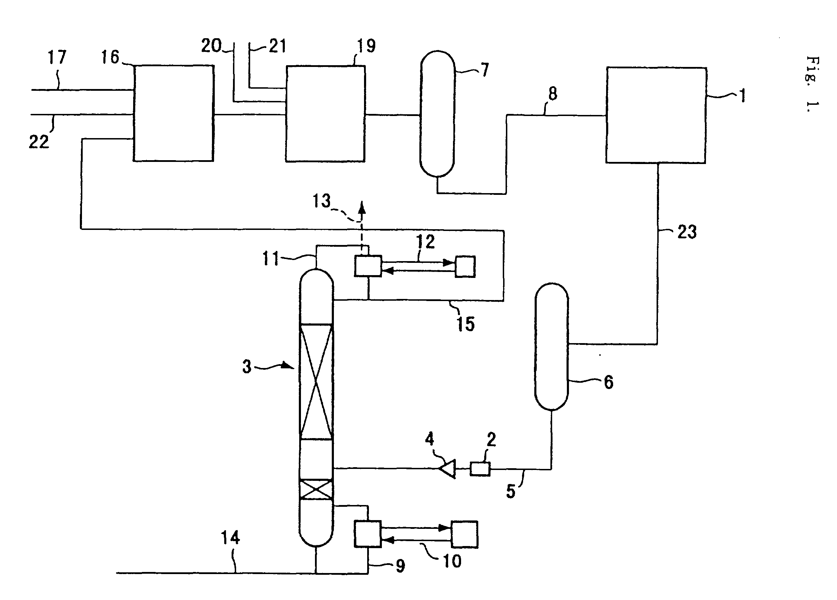

The objects and advantages of the invention will become apparent from the following detailed description of the preferred embodiments thereof in connection with the accompanying drawing, in which:

The drawing figure is a schematic diagram of a recycling apparatus in accordance with an exemplary aspect of the present invention.

### DETAILED DESCRIPTION OF THE PREFERRED EMBODIMENTS OF THE INVENTION

The invention will be explained in detail below with reference to the drawing appended herewith.

The drawing figure schematically depicts a recycling apparatus in accordance with an exemplary embodiment of the present invention. The recycling apparatus shown in the diagram principally includes a filter 2 which removes solids from the spent cleaning solution, i.e., the waste solution, discharged from the cleaning apparatus 1 employed in the semiconductor device fabrication process, a rectification column 3 which extracts concentrated aqueous ammonia from the solids-free waste solution, and a pump 4 which feeds the waste solution filtered across the filter 2 to the rectification column 3. Reference Number 5 refers to pipework.

The recycle of ammonia using the above-described recycling apparatus is carried out in accordance with the following method.

The cleaning solution itself is first prepared, for example, by mixing prescribed proportions of the following in the mixing element 19: high-purity aqueous ammonia afforded by purification in the ammonia purification component 16 of industrial-grade aqueous ammonia supplied from pipework 22, aqueous hydrogen peroxide fed from pipework 20, and pure water fed from pipework 21. The cleaning solution is stored in the tank 7 and is then fed into the cleaning apparatus 1 through pipework 8.

The cleaning solution fed into the cleaning apparatus 1 is used to clean semiconductor devices. During the cleaning of semiconductor devices with this cleaning solution, contaminants, such as organics and metals sticking or adsorbed on the surface of the substrate, are removed and thereby taken up by the cleaning solution.

When the contaminant concentration in the cleaning solution exceeds a prescribed value due to repetition of the cleaning process, the spent cleaning solution is discharged as a waste solution into the tank 6 through pipework 23 and fresh cleaning solution is fed into the cleaning apparatus 1 from the tank 7 through pipework 8. Since almost all of the hydrogen peroxide present in the cleaning solution goes to degrading the organics, hydrogen peroxide is essentially not present in the waste solution under consideration. This waste solution is stored in the tank 6, for example, at ambient temperature (e.g., 30°C) and ambient pressure.

The waste solution stored in the tank 6 is filtered across the filter 2 placed along the course of the pipework 5. This filter 2 almost completely removes the solids, such as particulates, present in the waste solution. A commercial filter can be employed as the filter 2. The filter 2 is preferably a filter that has the ability to remove solids with a particle size of 0.005 m or more, and more preferably that has the ability to remove solids with a particle size of 0.003 m or more.

After filtration across the filter 2, the waste solution is pressurized to about 4 atm by action of the pump 4 and is fed to the middle section of the rectification column 3. At this point, the waste solution will contain at most about 300 moles ammonia component for each approximately 1,000 moles waste solution introduced into the rectification column 3. The pressure of the waste solution has preferably been brought into the range of from 3.5 to 6 atm.

The waste solution fed into the rectification column 3 is extracted from the bottom of the rectification column 3 and is then fed to the heater 10 through pipework 9. The waste solution transported to the heater 10 is heated to around the saturation temperature for the aqueous ammonia at the column bottom at a pressure of about 4.1 atm, for example, about 130°C. This results in the gasification of a portion of the waste solution with the production of an ammonia-containing steam. The heating temperature of the heater 10 will vary as a function of the internal pressure in the rectification column 3, but as a general matter is preferably in the range of from 120 to 145°C.

The steam produced as described above and the ungasified components present in the waste solution are returned to the bottom of the rectification column 3. The steam returned to the bottom of the rectification column 3 rises in the rectification column 3 and finally reaches the top of the rectification column 3.

The steam that has reached the top of the rectification column 3 is extracted and fed to a cooler 12 via pipework 11. The steam fed to the cooler 12 is cooled, for example, to about 5°C at a pressure of about 3.9 atm. This results in condensation of almost all of the steam into a liquid. The component not liquefied by this cooling is discharged as low-boiling impurity gas through discharge outlet 13. The cooling temperature of the cooler 12 will vary as a function of the internal pressure of the rectification column 3, but as a general matter is preferably in the range of from 0 to 10°C. The low-boiling impurity gas will contain nitrogen, air, carbon dioxide, and relatively low-boiling organics such as methane.

A portion of the liquefied steam, that is, a portion of the fraction containing a relatively high concentration of ammonia, is returned to the top of the rectification column 3. This fraction returned to the rectification column 3 descends therein as reflux and thereby comes into countercurrent contact with the low-boiling component gas ascending within the rectification column 3. This process results in the repeated condensation and re-evaporation of the steam, which in turn results in an increase at the bottom of the rectification column 3 of those components having a boiling point above the aforesaid heating temperature or having lower vapor pressures at the heating temperature, that is, high-boiling components such as relatively high molecular weight organics.

As a consequence, high-boiling components can be efficiently removed from the waste solution in the rectification column 3 by extracting waste solution in which high-boiling components have become concentrated from the bottom of the rectification column 3, and discharging a portion thereof through pipework 14. The quantity of waste solution discharged through pipework 14 is preferably from about 5 to 15 vol% of the quantity of waste solution fed into the rectification column 3 through pipework 5. This set-up makes possible an efficient removal of high-boiling components and a highly efficient recovery of the ammonia. When, for example, the quantity of waste solution discharged through pipework 14 is brought to about 10 vol% of the quantity of waste solution fed into the rectification column 3 through pipework 5, the waste solution discharged through pipework 14 will contain about 2 mol% ammonia component.

The above-described process also results in an increase in the fraction of low-boiling component (component with a boiling point equal to or less than the aforesaid heating temperature or with the higher vapor pressure at the aforesaid heating temperature) in the low-boiling component gas ascending in the rectification column 3 as it approaches the column top. The mixed gas extracted from the top of the rectification column 3 will, as a consequence, contain a very high fraction of ammonia and almost no high-boiling component such as relatively high molecular weight organics. Ammonia will make up, for example, 90 mol% of the mixed gas discharged from the top of the rectification column 3.

As mentioned above, the mixed gas extracted from the top of the rectification column 3 is cooled in the cooler 12. A portion of this mixed gas is thereby liquefied while a low-boiling impurity gas comprising the unliquefied component is discharged through the discharge outlet 13. Thus, one fraction afforded by the rectification of the waste solution by the rectification column 3 is a concentrated aqueous ammonia from which high-boiling components and low-boiling impurity gas have both been removed. For example, a concentrated aqueous ammonia fraction containing about 270 moles ammonia can be produced when a waste solution containing approximately 300 moles ammonia is fed into the rectification column 3.

The concentrated aqueous ammonia produced by the above-described method will contain trace amounts of low-boiling impurities (e.g., oxygen, nitrogen, hydrocarbon, carbon dioxide, and carbon monoxide) resulting from dissolution during liquefaction by the cooler 12. When the impurity concentration in this concentrated aqueous ammonia exceeds 30 ppb, the concentrated aqueous ammonia is preferably forwarded to an ammonia purification component 16 through pipework 15 in order to remove the dissolved low-boiling impurities.

This ammonia purification component 16 may have any format as long as it has the ability to reduce the concentration of low-boiling impurities to 30 ppb or less. As an example, the ammonia purification component 16 may be a rectification column of the same type as the rectification column 3.

In addition, the ammonia purification component 16 may, for examples, include principally a container that stores the concentrated aqueous ammonia and a scrubber that scrubs an evaporated component from the upper region of the container's interior with a saturated aqueous solution of high-purity ammonia. In an ammonia purification component 16 of this type, a portion of the impurities present in the concentrated aqueous ammonia do not undergo gasification during gasification of the ammonia in the container and remain in the solution. As a result, some portion of the impurities present in the concentrated aqueous ammonia will already be removed from the gasified component.

The gasified component is also scrubbed with a saturated aqueous solution of high-purity aqueous ammonia, i.e., is brought into gas/liquid contact with high-purity aqueous ammonia. The impurities present in the gasified component are thereby taken into the high-purity aqueous ammonia with the production of a high-purity ammonia gas. The resulting ammonia gas is then dissolved in pure water supplied from pipework 17 to give a high-purity aqueous ammonia.

The high-purity aqueous ammonia produced as described above is fed to the mixing element 19 through pipework 18. There are connected to the mixing element 19 a pipework 20 that supplies aqueous hydrogen peroxide, and a pipework 21 that feeds pure water as necessary. The high-purity aqueous ammonia, aqueous hydrogen peroxide, and pure water fed into the mixing element 19 are intermixed in prescribed proportions to give the cleaning solution.

The cleaning solution can also be prepared at the same time as production of the high-purity aqueous ammonia in the ammonia purification component 16. Specifically in this case, the cleaning solution can be prepared by dissolving the high-purity ammonia gas in aqueous hydrogen peroxide.

The cleaning solution produced by the above-described method is fed to the tank 7 through pipework 22. The cleaning solution stored in the tank 7 is fed to the cleaning apparatus 1 through pipework 8 and used to clean semiconductor devices. Operating as described above, up to, for example, about 90% of the ammonia in the cleaning solution can be recycled to the cleaning step in semiconductor processing.

As has been explained above, purification of the concentrated aqueous ammonia in the ammonia purification component 16 becomes necessary in the subject recycle method when the concentrated aqueous ammonia afforded by the rectification column 3 has an impurity concentration in excess of 30 ppb. In general, the high-purity aqueous ammonia used to clean semiconductor devices is a commercially acquired high-purity aqueous ammonia or a high-purity aqueous ammonia prepared onsite by purification of industrial-grade aqueous ammonia. In the former case, the ammonia purification component 16 will not already be present in the semiconductor fabrication plant and thus will have to be separately installed in order to carry out the herein-described recycling. In the latter case, however, the ammonia purification component 16 will already be present in the semiconductor fabrication plant and the concentrated aqueous ammonia produced by the rectification column 3 can simply be fed to this existing ammonia purification component 16.

The gas fraction extracted from the top of the rectification column 3 can be fed in the gaseous state to a purifier. While this will prevent the removal of low-boiling impurity gas at the rectification column 3, the low-boiling impurity gas can be removed in the ammonia purification component 16.

Ammonia, propane, a fluorocarbon substitute, and the like can be employed as the refrigerant in the cooler 12 at the rectification column 3. The heat source for the heater 10 can be exemplified by steam, a hot gas, or electricity.

The present invention ultimately produces high-purity aqueous ammonia from the waste solution discharged from the cleaning of semiconductor substrates with an ammonia-containing cleaning solution by use of solids removal means to remove the solids from this waste solution, and use of the rectification column to remove high-boiling components, such as relatively high molecular weight organics, from the waste solution.

In sum, the present invention provides a recycling apparatus and method that can recycle ammonia already used for cleaning during semiconductor device fabrication back to the cleaning process.

While the invention has been described in detail with reference to specific embodiments thereof, it will be apparent to those skilled in the art that various changes and modifications can be made, and equivalents employed, without departing from the scope of the appended claims.

## Claims

1. A recycling apparatus connected to a semiconductor cleaning apparatus engaged in cleaning semiconductor substrates with an ammonia-containing cleaning solution, the recycling apparatus recovering ammonia from a waste solution discharged from the cleaning apparatus and purifying the waste solution for re-use of the recovered ammonia in the cleaning apparatus, said recycling apparatus comprising:
a solids removal means for removing solids from the waste solution;
a rectification column for rectifying the waste solution from which the solids have been removed, the column yielding concentrated aqueous ammonia at the column top;
a first pipework for feeding the waste solution discharged from the semiconductor cleaning apparatus to the solids removal means;
a second pipework for feeding from the solids removal means the waste solution from which the solids have been removed to the rectification column; and
a third pipework for removing from the rectification column and feeding to the cleaning apparatus the concentrated aqueous ammonia.

2. The recycling apparatus of claim 1, wherein the rectification column removes at least a portion of the chemical substances having a boiling point below that of ammonia in the concentrated aqueous ammonia.

3. The recycling apparatus of claim 2, further comprising a purifier connected to the third pipework for producing high-purity aqueous ammonia having an impurity concentration of 30 ppb or less by purifying the concentrated aqueous ammonia which has been freed of at least a portion of the chemical substances having a boiling point less than that of ammonia.

4. The recycling apparatus of claim 1, wherein the cleaning solution is a mixture comprising ammonia, hydrogen peroxide, and pure water.

5. A recycling method for recovering ammonia from a waste solution discharged from a semiconductor cleaning apparatus engaged in cleaning semiconductor substrates with an ammonia-containing cleaning solution, and purifying the waste solution for re-use of the recovered ammonia in the cleaning, the method comprising:
removing solids from the waste solution; and
rectifying the waste solution from which the solids have been removed, thereby producing a concentrated aqueous ammonia at the column top.

6. The method of claim 5, wherein the cleaning solution is a mixture comprising ammonia, hydrogen peroxide and water.

7. The method of claim 5, further comprising removing from the concentrated aqueous ammonia at least a portion of the chemical substances having a boiling point less than that of ammonia.

8. The recycling apparatus of claim 7, wherein the cleaning solution is a mixture comprising ammonia, hydrogen peroxide, and pure water.

9. The method of claim 7, further comprising producing high-purity aqueous ammonia having an impurity concentration of 30 ppb or less by purifying the concentrated aqueous ammonia that has been freed of at least a portion of the chemical substances having a boiling point less than that of ammonia.

10. The recycling apparatus of claim 9, wherein the cleaning solution is a mixture comprising ammonia, hydrogen peroxide, and pure water.
